# EUROPEAN PATENT SPECIFICATION

(11) **EP 2 592 400 B1**
(45) Date of publication and mention of the grant of the patent: **22.12.2021**
(21) Application number: 12192635.6
(22) Date of filing: 14.11.2012
(51) Int. Cl.: G01J 1/42, G01R 31/26

(54) **Analysing light sources**
Analyse von Lichtquellen
Analyse de sources de lumière

(30) Priority: 14.11.2011 GB 201119618
(43) Date of publication of application: 15.05.2013
(73) Proprietor: Feasa Enterprises Limited, Castletroy (IE)
(72) Inventor: O'Toole, Eamonn, Limerick (IE); Davern, Timothy, Limerick (IE); Crowley, Michael, Limerick (IE)
(74) Representative: Chettle, John Edward

(56) References cited:
- DE-A1- 19 515 865
- KR-A- 20110 092 006
- US-A1- 2011 231 130
- US-B2- 7 056 000
- US-B2- 7 601 941
- Chroma Ate Inc.: "Test & Measurement Products Catalog 2006", 2006, http://web.archive.org/web/20060319195430/ http://www.chromaate.com/chroma/catalogue/ 4/2006_general%20catalog_e.pdf, XP002692288, * pages 13-21 - pages 13-22 *

## Description

### Field

The invention relates to analysing light sources. Particularly, but not exclusively, the invention relates to an apparatus and method for testing LED light sources.

### Background

It is often preferable that light sources, for example light sources comprising one or more light emitting diodes (LED's), output light which complies with a particular standard or set of standards. For example, it may be preferable that a group of LED's have substantially the same light emitting characteristics to provide consistency of light emission across the group. DE 195 15 865 A1, US 7 056 000 B2, US 2011/231130 A1 and KR 2011 0092006 A describe light source analysing devices.

### Summary

According to the invention, there is provided a light source analysing device, according to independent claims 1 and 4.

The device may be configured to determine upper and lower threshold values of the property of light by applying the tolerance to the configuration value.

The device may be configured to determine the upper threshold value by adding the tolerance to the configuration value and/or to determine the lower threshold value by subtracting the tolerance from the configuration value.

According to the invention, there is provided a method of analysing a light source, according to claims 7 and 10.

The method may comprise determining upper and lower threshold values of the property of light by applying the tolerance to the configuration value.

The method may comprise determining the upper threshold value by adding the tolerance to the configuration value and/or determining the lower threshold value by subtracting the tolerance from the configuration value.

For exemplary purposes only, embodiments of the invention are described below with reference the accompanying figures in which:

### Brief description of the figures

Figure 1 is a schematic illustration of a light analysing apparatus configured to measure light received from a light source and to determine whether the light source complies with a standard based on the measured light;
figure 2 is a flow diagram of a method of analysing light sources;
figure 3 is an example of a display of user-inputted tolerance information on a screen of the apparatus; and
figure 4 is an example of a display of generated upper and lower tolerances for a plurality of different measured properties of light received from a plurality of different external light sources.

### Detailed description

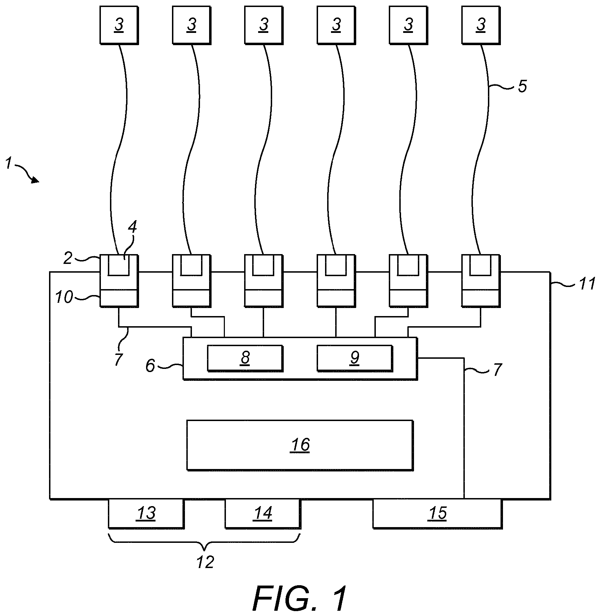

A light source analysing apparatus 1 is illustrated in figure 1. The apparatus 1 comprises one or more light sensors 2 which are configured to detect properties of light emitted from one or more light sources 3. The analysing apparatus 1 is configured to automatically measure the detected properties of the light received from the light source(s) 3 to determine test thresholds for one or more properties of the light. Subsequently, the apparatus 1 is configured to indicate how light detected from individual light sources 3 compares with the test thresholds.

In the subsequent description, the light sources 3 will be described in terms of light emitting diode (LED) light sources 3 which include either a single LED or a plurality of LED's configured to output visible light. However, the description can equally be applied to light sources 3 which do not incorporate LED's or which output light in a non-visible part of the electromagnetic spectrum.

Each light sensor 2 comprises a light entry port 4 through which light can enter the sensor 2. The light entry port 4 may, for example, configured to receive light emitted from an LED light source 3 which is associated with the sensor 2. The light is received via an optical coupling such as a light guide 5. An example of a suitable light guide 5 is an optical fibre coupled between the LED light source 3 and the light entry port 4. In this case, the light entry port 4 is configured to connect to a light exit end of the optical fibre, or other light guide 5, so that light emitted by the LED light source 3 into a light entry end of the light guide 5 is channelled into the light entry port 4 for detection. The optical fibre or other light guide 5 may optionally be integrally formed with the light entry port 4. Each light sensor 2 may comprise one or more lenses, mirrors or other light directors to focus or otherwise direct the light into the sensor 2 as required.

A plurality of the above-described light sensors 2 and light guides 5 enables the analysing apparatus 1 to simultaneously detect light emitted by a corresponding plurality of separate light sources 3. For example, each of the plurality of light sensors 2 may be optically coupled to a different one of a corresponding plurality of light sources 3 via separate light guides 5 so that each light sensor 2 receives and detects light emitted from a different light source 3. In this way, the light received from each of the plurality of light sources 3 can be individually and simultaneously analysed by the apparatus 1. As explained below, the cumulative results produced by analysis of the plurality of light sources 3 may be used by the apparatus 1 to establish test thresholds for a plurality of properties of light. The established thresholds may subsequently be used by the apparatus 1 to test the individual light sources 3.

The light sensors 2 are configured to detect the properties of received light in the visible, infra-red and ultra-violet parts of the electromagnetic spectrum. Examples of these properties are the colour, intensity and wavelength and/or frequency of the received light, although the sensors 2 may be additionally configured to detect other properties of light.

Signals indicative of the properties of the light detected by the sensors 2 are communicated to a controller 6 of the testing apparatus 1 via communication couplings 7 between the sensors 2 and the controller 6. The controller 6 may comprise an electronic controller such as microcontroller which includes a processor 8 and a memory 9. The communication couplings 7 may comprise electrical connections between the sensors 2 and the controller 6, which are arranged so that each light sensor 2 can communicate with the controller 6 independently of the other sensors 2 via electrical signals.

In more detail, the signals indicative of the properties of received light may be generated by transducers 10 which are configured to create electrical signals in dependence of the properties of the received light. For example, as shown in figure 1, each light sensor 2 may include a transducer 10 which is configured to generate an electrical signal in dependence of the light received at the sensor 2. The generated signal includes information describing the detected properties of light received at that sensor 2. The sensor 2 is configured to send the generated signal to the controller 6. The information in the signal may comprise values of the properties of received light, as measured by the sensor 2, or may comprise information which is sufficient for the controller 6 to measure the values of the properties of the received light. In the latter case, the controller 6 is configured to measure the values of the properties based on the information in the signal.

In terms of the measuring process, a colour of received light may be measured as a value of one or more of XY chromaticity, correlated colour temperature (CCT), RGB (Red, Green, Blue) and HSI (Hue, Saturation, Intensity). An intensity of the received light may be measured as a value in one or more of lumens, milicandela (mcd) and lux. The wavelength of the received light may be measured as a value in metres or any fraction of a metre such as mm, µm or nm. The frequency of the received light may be measured in hertz. Each different unit of measurement may be classified as a separate property of the received light, as referred to further below.

Referring to figure 1, the light analysing apparatus 1 may be embodied as a single, compact unit having a protective housing 11 which forms the exterior surface of the unit. The controller 6, communication couplings 7, processor 8 and memory 9 may all be located inside the housing 11. The light entry ports 4 of the light sensors 2 may be located at the exterior surface of the housing 11 so that light received from the external light sources 3 can be detected from ends of the light guides 5. Alternatively, the light guides 5 may extend into the housing 11 so that the light entry ports 4 can be provided inside the housing 11. Other parts of the light sensors 2 may also be located inside the housing 11. For example, as shown in figure 1, the transducers 10 may be located inside the housing 10. However, it will be appreciated that the transducers 10 could alternatively be located at the housing's exterior surface.

In addition to the light entry ports 4, the external surface of the housing 11 may be provided with user indicators 12 which the apparatus 1 is configured to use for communicating information to a user. The user indicators 12 may comprise a visual display 13, such as a dot-matrix or LCD screen, which is communicatively coupled to the controller 6 so that the controller 6 is configured to cause visual information such as text or pictures to be displayed to the user of the apparatus 1 on the display 13. The user indicators 12 may additionally or alternatively comprise one or more other types of visual indicator such as one or more lights (e.g. LED's) which are configured to switch on and off under the control of the controller 6 to display the visual information. The user indicators 12 may additionally or alternatively comprise audible indicators such as one or more loudspeakers 14 provided on or in the housing 11 for outputting audible information under the control of the controller 6.

The apparatus 1 may also comprise a data input unit 15, for example comprising a keyboard, through which a user can enter information into the apparatus 1 to be stored in the memory 9 and used in a light analysing process. Optionally, the data input unit 15 may comprise a wireless transceiver configured to receive the information wirelessly from an external user device such as a mobile telephone or other wireless communication unit. According to the invention, the information comprises tolerances which the controller 6 is configured to apply to configuration values of the properties of received light to determine upper and lower test threshold values for the properties. The configuration values are derived by the apparatus 1 directly from the values for each property measured from the light sources 3. This is described in detail further below. As previously mentioned, once established, the threshold values are used to test light received from individual light sources 3 to determine whether the individual light sources 3 comply with a required standard.

The components of the apparatus 1 such as the sensors 2, controller 6 and user indicators 12 may be powered by a power supply unit 16 of the apparatus 1. As shown in figure 1, the power supply unit 16 may be located inside housing 11. The power supply unit 16 is configured to receive electrical power from one or more power sources, such as a re-chargeable battery or fuel cell removably located inside the housing 11 or an external mains-voltage power source via an external power lead. The power supply unit 16 may include a step-down transformer for providing appropriate low-voltage power to the apparatus components.

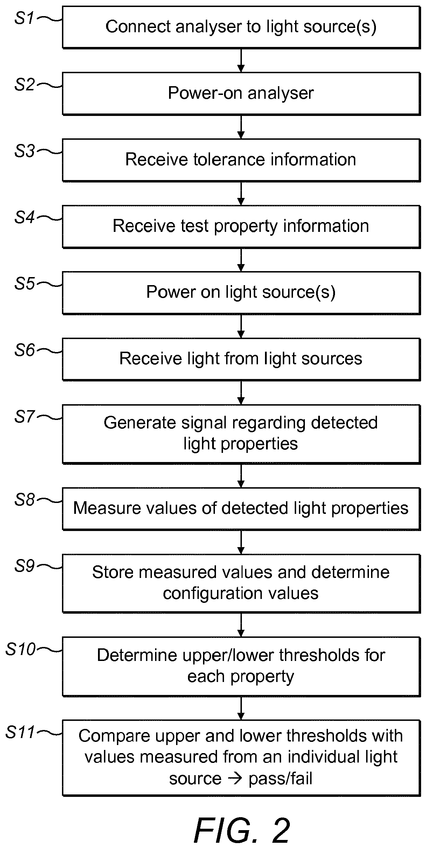

As briefly referred to above, the analysing apparatus 1 is configured to automatically use the measured values of the properties of received light to create one or more test thresholds for use in testing individual light sources 3. The creation of the test thresholds and subsequent decision regarding whether or not light received from an individual source 3 passes the test may be carried out in the controller 6 previously described. A method for establishing test thresholds, testing received light and outputting a test result for the received light, and thus the light source 3 from which the light was emitted, is described below with reference to figure 2. When executed by the processor 8 in the controller 6, a computer program stored in the memory 9 of the controller 6 may cause a plurality of steps of the method described below to be performed by the apparatus 1.

In a first step S1 of an example analysis method, the light analysing apparatus 1 is connected to an external LED light source 3 via an optical fibre or other light guide 5. A light entry end of the light guide 5 is optically connected to the LED light source 3 so that substantially all of the light emitted by the light source 3 enters the light guide 5. A light exit end of the light guide 5 is optically connected to a light entry port 4 of the analysing apparatus 1 so that light propagating along the light guide 5 from the light source 3 will enter the light entry port 4 and be detected by the light sensor 2.

In a second step S2 of the method, the light analysing apparatus 1 is powered-on in preparation to receive light from the LED light source 3.

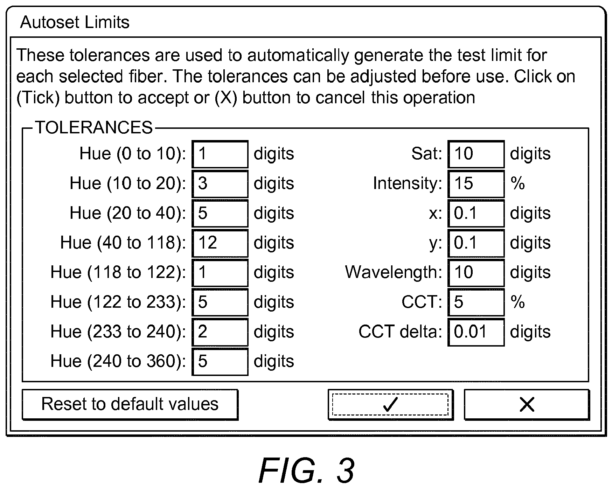

Referring to figure 3, in a third step S3 of the method, the light analysing apparatus 1 receives tolerance information individually relating to one or more properties of light. The tolerance information comprises one or more first tolerances relating to a first property, one or more second tolerances relating to a second property, one or more third tolerances relating to a third property and so on. Specifically, tolerance information are individually provided for each property of light which can be detected by the sensors 2. As previously described, the properties may comprise colour, intensity, wavelength and frequency. The properties may also be specific to the unit in which the measurement is taken, such as lumens, lux, hertz, degrees Kelvin and metres.

The tolerance information may be received by the data input unit 15 and communicated to the controller 6 via an electrical communication coupling 7. The controller 6 is configured to store the tolerance information in the memory 9 for later use when creating the test thresholds, as described below. The tolerance information may be user generated so that a user can control and adjust the tolerances used in the test.

In a fourth step S4 of the method, the light analysing apparatus 1 receives information detailing which properties of light should be measured and tested during the test process. As with the tolerance information, this information may be received by the data input unit 15 based on a user input, communicated to the controller 6 and stored in the memory 9 for use during the test.

In a fifth step S5 of the method one or more LED light sources 3 optically coupled to the apparatus 1 are powered-on and begin to emit light into the light entry ends of the light guides 5.

A sixth step S6 of the method comprises the light sensors 2 receiving and detecting the light from the light sources 3 via the exit ends of the light guides 5.

In a seventh step S7, the light sensors 2 each generate a signal which includes information describing properties of the light detected by the sensor 2. The sensors 2 automatically send the signals to the controller 6 as previously described. The signals may be generated by the sensors' transducers 10.

In an eighth step S8 of the method, the controller 6 receives the information signals from the sensors 2 and uses the information to measure values of the properties of light received at the sensors 2. The properties which are measured by the controller 6 are retrieved from the memory 9. The retrieved properties are those which were identified by the user information received at the data input unit 15 in the above-described fourth step S4. As already mentioned, the measurement of values may alternatively be performed by the light sensors 2 so that the information signals received at the controller 6 include the measured values for each light source 3.

The result of the eighth step S8 is a measured value for each property of light identified in the fourth step S4, for each light source 3 optically coupled to the apparatus 1. Therefore, if a plurality of light sources 3 arc simultaneously coupled to the apparatus 1, the result is a plurality of measured values for each identified property of light.

In a ninth step S9, the measured values of the identified properties are, at least temporarily, stored in the memory 9 by the controller 6.

A tenth step S10 of the method comprises a test threshold configuration step in which the controller 6 applies the tolerances to configuration values for each property identified by the information received in the fourth step S4 to determine upper and lower test thresholds for the properties of light. In the configuration step, the stored measured values are used directly as configuration values or are averaged to create the configuration values. This is described in detail below.

The tenth step S10 is carried out automatically by the controller 6 upon having measured the values or having received the measured values from the sensor 2. The upper and lower test thresholds are then stored in the memory 9 so that they can be compared with values measured from individual light sources 3 during testing. Application of the tolerances may comprise performing a mathematical operation using a configuration value and a related tolerance value as inputs. For instance, a tolerance value may be added to a configuration value to create an upper threshold value and subtracted from the configuration value to create a lower threshold value. A plurality of tolerance values are illustrated in figure 3. Using figure 3 as a specific example, the application of a tolerance value of '15% of the configuration value' to a configuration value of '100' for the property 'Intensity' comprises causing the controller 6 to calculate an upper threshold value of 115% of the configuration intensity value and a lower threshold value of 85% of the configuration intensity value.

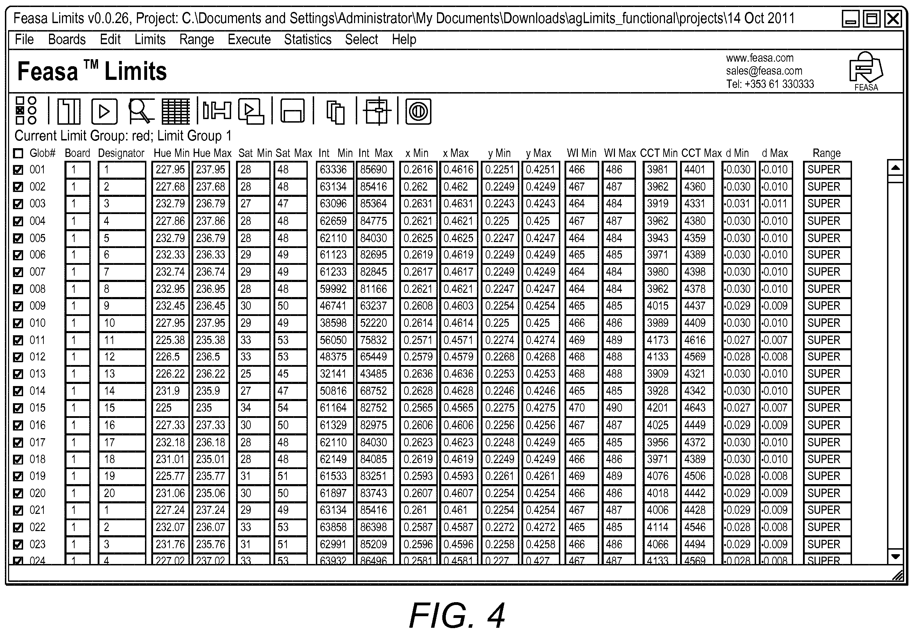

The controller 6 is configured to carry out the tenth step S10 for all of the properties of light which are identified by the information received in the fourth step S4. As can be seen from figure 4, each of these properties may correspond to measurement of a specific unit of the received light. Optionally, the controller 6 may select one of a plurality of different tolerances specific to one of the identified properties depending on the configuration value. Specifically, the value of the applied tolerance is different for different configuration values. For example, referring to the 'Hue' example illustrated in figure 3, the controller 6 may be configured to apply a small first tolerance if the configuration value is in a lower, first range and a second, larger tolerance if the configuration value is higher, second range. A third, even larger tolerance may be applied if the configuration value is in still higher, third range.

Optionally, the configuration step S10 may be carried out based on light received from a single light source 3 which is known to emit light having the required light property values.

If light is being simultaneously received from a plurality of different light sources via the different ones of the light sensors 2, then the controller 6 is configured to carry out the tenth step S10 independently for all of the different light sources 3 in a simultaneous fashion. In this case, the light analysis apparatus 1 measures values specific to each light source 3 to which it is optically connected and so a plurality of measured values for each property identified by the information received in the fourth step S4 are stored in the memory 9. The controller 6 is configured to average the measured values for each property to generate a single configuration value for each property. In this way, one configuration value is generated for each property to be tested. This single value takes into account the light measured from all of the light sources 3 connected to the analysing apparatus 1. Any suitable averaging method can be used to generate the configuration values, such as generating a mean, mode or median value from the plurality of measured values for each property.

For example, if 100 light sources 3 are optically coupled to the light analysing apparatus 1 and the information received in the fourth step identifies first, second and third properties of light to be tested, the measurement of light from the light sources 3 produces 100 values for the first property, 100 values for the second property and 100 values for the third property. An average of the 100 first values produces a configuration value for the first property, an average of the 100 second values produces a configuration value for the second property and an average of the 100 third values produces a configuration value for the third property.

If the controller 6 averages the measured values to create a single configuration value for each property to be tested, the averaging may take place in a step S9a before the tenth step S10 described above so that the tolerances are applied to the averaged configuration value for each property to determine the upper and lower thresholds.

As a second option, the controller 6 is configured to apply the tolerances to all of the measured values for the individually measured light sources 3, thereby generating a plurality of different upper and lower thresholds for each property. In this scenario, the controller 6 employs each measured value as a separate configuration value so that, in the tenth step S10, tolerances are applied to configuration values specific to each measured light source 3. To use the example given above, this approach produces 100 configuration values for the first property, 100 configuration values for the second property and 100 configuration values for the third property. From these configuration values, a corresponding number of upper and lower threshold values, also referred to as tolerated configuration values, are produced upon application of the relevant stored tolerances. An example of this can be seen in figure 4, in which tolerances have been applied by the controller 6 to a plurality of different configuration values measured from a plurality of different light sources 3 to produce a plurality of upper and lower tolerated configuration values for each property. The controller 6 may then be configured to average the plurality of upper tolerated configuration values and lower tolerated configuration values for each property to produce a single upper and lower test threshold for each property. Any suitable averaging method can be used, as previously described in the discussion of generating an average configuration value for each property.

As with the first approach, the upper and lower threshold values determined by the second approach take into account the light measured from all of the light sources 3 connected to the analysing apparatus 1.

In an eleventh step S11, the controller 6 is configured to compare the upper and lower test thresholds determined in the tenth step S10 with values measured from individual light sources 3 and to output an indication as to how the measured values compare with the thresholds. These individual light sources 3 may be individual ones of the plurality of light sources which were used to establish the upper and lower test thresholds, or may be different light sources 3 not used to establish the thresholds.

Having carried out the comparison in the eleventh step S11, if the controller 6 finds that the measured value is between the upper and lower test thresholds, the apparatus 1 is configured to indicate that the light source 3 from which the value was measured 'passes' the test for the property of light in question. Conversely, if the controller 6 determines that the measured value does not fall between the upper and lower thresholds, then the apparatus 1 is configured to indicate that the light source 3 'fails' the test for the property of light in question. All of the properties identified by the information received in the fourth step S4 of the above-described method are checked against the relevant generated upper and lower thresholds and separate indications of pass/fail are output for each property. If the measured values relating to one or more light sources 3 fall between the threshold limits for all of the identified properties, a further indication is given by the apparatus 1 that the light source(s) 3 pass the test for all tested light properties. The indications may be generated either visually or audibly using any of the indicators 12 previously described.

The apparatus 1 is configured to store different groups of upper lower thresholds which are specific to different types of light source 3. Each group of thresholds comprises a first upper and lower thresholds for a first property, second upper and lower thresholds for a second property, third upper and lower thresholds for a third property and so on, for different types of light source 3 so that the apparatus 1 can select the appropriate group of thresholds for testing in dependence of the type of light source 3 being tested. Figure 4 illustrates the establishment of a group of Red LED test thresholds by measuring light received from a plurality of Red LED's. It will be appreciated that different groups could be created for other colours of LED, and different types of light source 3, by establishing test thresholds using measured values from the relevant type of light source 3.

All of the groups of thresholds are stored in memory and may be selected by the user, for example using the data input unit 15, before testing a new set of recently connected light sources 3.

## Claims

1. A light source analysing device, comprising:
one or more light sensors (2) optically coupled via at least one light guide (5) to at least one external light source (3); and
a controller (6) to receive signals indicative of the properties of the light detected by the sensor(s), wherein the sensor(s) and the controller are configured to:
measure a value of a property of light received from the at least one external light source;
determine from the measured value of said property of received light a configuration value of said property of light, wherein determining the configuration value comprises using the measured value directly
as the configuration value;
select one of a plurality of different tolerances specific to said property of light depending on the configuration value, wherein the plurality of different tolerances specific to said property of light are stored in a memory of the device;
determine a threshold of said property of light by applying the selected tolerance to the configuration value;
store the threshold in the memory of the device;
compare a value of said property of light measured from light received from another external light source with the threshold; and
output an indication of a result of the comparison.

2. A device according to claim 1, wherein the device is configured to determine upper and lower threshold values of the property of light by applying the tolerance to the configuration value.

3. A device according to claim 2, wherein the device is configured to determine the upper threshold value by adding the tolerance to the configuration value and to determine the lower threshold value by subtracting the tolerance from the configuration value.

4. A light source analysing device, comprising:
a plurality of light sensors (2) optically coupled via at least one light guide (5) to a plurality of external light sources (3); and
a controller (6) to receive signals indicative of the properties of the light detected by the sensor(s), wherein the sensor(s) and the controller are configured to:
individually measure values of a property of light received from the plurality of external light sources;
determine from the measured values of said property of received light a configuration value of said property of light, wherein determining the configuration value comprises averaging the measured values from the plurality of light sources to produce an average value as the configuration value;
select one of a plurality of different tolerances specific to said property of light depending on the configuration value, wherein the plurality of different tolerances specific to said property of light are stored in a memory of the device;
determine a threshold of said property of light by applying the selected tolerance to the configuration value;
store the threshold in the memory of the device;
compare a value of said property of light measured from light received from another external light source with the threshold; and
output an indication of a result of the comparison.

5. A device according to claim 4, wherein the device is configured to determine upper and lower threshold values of the property of light by applying the tolerance to the configuration value.

6. A device according to claim 5, wherein the device is configured to determine the upper threshold value by adding the tolerance to the configuration value and to determine the lower threshold value by subtracting the tolerance from the configuration value.

7. A method of analysing a light source using the light source analysing device of any one of claims 1-3, comprising:
measuring, by the device, a value of a property of light received from at least one external light source to determine from the received light a configuration value of said property of light, wherein determining the configuration value comprises using the measured value directly as the configuration value;
selecting, by the device, one of a plurality of different tolerances specific to said property of light depending on the configuration value, wherein the plurality of different tolerances specific to said property of light are stored in a memory of the device;
determining, by the device, a threshold of said property of light by applying a tolerance to the configuration value;
storing, by the device, the threshold in the memory of the device;
comparing, by the device, a value of said property of light measured from light received from another external light source with the threshold; and
outputting, by the device, an indication of a result of the comparison.

8. A method according to claim 7, comprising determining upper and lower threshold values of the property of light by applying the tolerance to the configuration value.

9. A method according to claim 8, comprising determining the upper threshold value by adding the tolerance to the configuration value and determining the lower threshold value by subtracting the tolerance from the configuration value.

10. A method of analysing a light source using the light source analysing device of any one of claims 4-6, comprising:
individually measuring, by the device, values of a property of light received from a plurality of external light sources to determine from the received light a configuration value of said property of light, wherein determining the configuration value comprises averaging the measured values from the plurality of light sources to produce an average value as the configuration value;
selecting, by the device, one of a plurality of different tolerances specific to said property of light depending on the configuration value, wherein the plurality of different tolerances specific to said property of light are stored in a memory of the device;
determining, by the device, a threshold of said property of light by applying a tolerance to the configuration value;
storing, by the device, the threshold in the memory of the device;
comparing, by the device, a value of said property of light measured from light received from another external light source with the threshold; and
outputting, by the device, an indication of a result of the comparison.

11. A method according to claim 10, comprising determining upper and lower threshold values of the property of light by applying the tolerance to the configuration value.

12. A method according to claim 11, comprising determining the upper threshold value by adding the tolerance to the configuration value and determining the lower threshold value by subtracting the tolerance from the configuration value.

## Patentansprüche

1. Lichtquellenanalysevorrichtung, umfassend:
einen oder mehrere Lichtsensoren (2), die über zumindest einen Lichtleiter (5) mit zumindest einer externen Lichtquelle (3) optisch gekoppelt sind; und
eine Steuerung (6), um Signale zu empfangen, die für die Eigenschaften des von dem/den Sensor(en) erfassten Lichtes indikativ sind, wobei der/die Sensor(en) und die Steuerung konfiguriert sind, um:
einen Wert einer Eigenschaft von Licht zu messen, das von der zumindest einen externen Lichtquelle empfangen wird;
vom gemessenen Wert der Eigenschaft des empfangenen Lichtes einen Konfigurationswert der Lichteigenschaft zu bestimmen, wobei das Bestimmen des Konfigurationswertes das direkte Verwenden des gemessenen Wertes als den Konfigurationswert umfasst;
eine von einer Vielzahl von unterschiedlichen Toleranzen abhängig vom Konfigurationswert auszuwählen, die für die Lichteigenschaft spezifisch sind, wobei die Vielzahl von unterschiedlichen Toleranzen, die für die Lichteigenschaft spezifisch sind, in einem Speicher der Vorrichtung gespeichert werden;
einen Schwellenwert der Lichteigenschaft durch Anwenden der ausgewählten Toleranz auf den Konfigurationswert zu bestimmen;
den Schwellenwert im Speicher der Vorrichtung zu speichern;
einen Wert der Lichteigenschaft zu vergleichen, gemessen vom Licht, das von einer weiteren externen Lichtquelle mit dem Schwellenwert empfangen wird; und
eine Anzeige eines Ergebnisses des Vergleichs auszugeben.

2. Vorrichtung nach Anspruch 1, wobei die Vorrichtung konfiguriert ist, um obere und untere Schwellenwerte der Lichteigenschaft durch Anwenden der Toleranz auf den Konfigurationswert zu bestimmen.

3. Vorrichtung nach Anspruch 2, wobei die Vorrichtung konfiguriert ist, um den oberen Schwellenwert durch Addieren der Toleranz zum Konfigurationswert zu bestimmen und um den unteren Schwellenwert durch Subtrahieren der Toleranz vom Konfigurationswert zu bestimmen.

4. Lichtquellenanalysevorrichtung, umfassend:
eine Vielzahl von Lichtsensoren (2), die über zumindest einen Lichtleiter (5) mit einer Vielzahl von externen Lichtquellen (3) optisch gekoppelt sind; und
eine Steuerung (6), um Signale zu empfangen, die für die Eigenschaften des von dem/den Sensor(en) erfassten Lichtes indikativ sind, wobei der/die Sensor(en) und die Steuerung konfiguriert sind, um:
Werte einer Eigenschaft von Licht individuell zu messen, das von der Vielzahl von externen Lichtquellen empfangen wird;
von den gemessenen Werten der Eigenschaft des empfangenen Lichtes einen Konfigurationswert der Lichteigenschaft zu bestimmen, wobei das Bestimmen des Konfigurationswertes die Mittelung der gemessenen Werte von der Vielzahl von Lichtquellen umfasst, um einen Mittelwert als den Konfigurationswert zu erzeugen;
eine von einer Vielzahl von unterschiedlichen Toleranzen abhängig vom Konfigurationswert auszuwählen, die für die Lichteigenschaft spezifisch sind, wobei die Vielzahl von unterschiedlichen Toleranzen, die für die Lichteigenschaft spezifisch sind, in einem Speicher der Vorrichtung gespeichert werden;
einen Schwellenwert der Lichteigenschaft durch Anwenden der ausgewählten Toleranz auf den Konfigurationswert zu bestimmen;
den Schwellenwert im Speicher der Vorrichtung zu speichern;
einen Wert der Lichteigenschaft zu vergleichen, gemessen vom Licht, das von einer weiteren externen Lichtquelle mit dem Schwellenwert empfangen wird; und
eine Anzeige eines Ergebnisses des Vergleichs auszugeben.

5. Vorrichtung nach Anspruch 4, wobei die Vorrichtung konfiguriert ist, um obere und untere Schwellenwerte der Lichteigenschaft durch Anwenden der Toleranz auf den Konfigurationswert zu bestimmen.

6. Vorrichtung nach Anspruch 5, wobei die Vorrichtung konfiguriert ist, um den oberen Schwellenwert durch Addieren der Toleranz zum Konfigurationswert zu bestimmen und um den unteren Schwellenwert durch Subtrahieren der Toleranz vom Konfigurationswert zu bestimmen.

7. Verfahren zum Analysieren einer Lichtquelle unter Verwendung der Lichtquellenanalysevorrichtung nach einem der Ansprüche 1 bis 3, umfassend:
Messen eines Wertes einer Eigenschaft von Licht durch die Vorrichtung, das von zumindest einer externen Lichtquelle empfangen wird, um vom empfangenen Licht einen Konfigurationswert der Lichteigenschaft zu bestimmen, wobei das Bestimmen des Konfigurationswertes das direkte Verwenden des gemessenen Wertes als den Konfigurationswert umfasst;
Auswählen einer von einer Vielzahl von unterschiedlichen Toleranzen abhängig vom Konfigurationswert durch die Vorrichtung, die für die Lichteigenschaft spezifisch sind, wobei die Vielzahl von unterschiedlichen Toleranzen, die für die Lichteigenschaft spezifisch sind, in einem Speicher der Vorrichtung gespeichert werden;
Bestimmen eines Schwellenwertes der Lichteigenschaft durch die Vorrichtung durch Anwenden einer Toleranz auf den Konfigurationswert;
Speichern des Schwellenwertes im Speicher der Vorrichtung durch die Vorrichtung;
Vergleichen eines Wertes der Lichteigenschaft gemessen vom Licht, das von einer weiteren externen Lichtquelle empfangen wird, durch die Vorrichtung mit dem Schwellenwert; und
Ausgeben einer Anzeige eines Ergebnisses des Vergleiches durch die Vorrichtung.

8. Verfahren nach Anspruch 7, umfassend das Bestimmen von oberen und unteren Schwellenwerten der Lichteigenschaft durch Anwenden der Toleranz auf den Konfigurationswert.

9. Verfahren nach Anspruch 8, umfassend das Bestimmen des oberen Schwellenwertes durch Addieren der Toleranz zum Konfigurationswert und das Bestimmen des unteren Schwellenwertes durch Subtrahieren der Toleranz vom Konfigurationswert.

10. Verfahren zum Analysieren einer Lichtquelle unter Verwendung der Lichtquellenanalysevorrichtung nach einem der Ansprüche 4 bis 6, umfassend:
individuelles Messen von Werten einer Eigenschaft von Licht durch die Vorrichtung, das von einer Vielzahl von externen Lichtquellen empfangen wird, um vom empfangenen Licht einen Konfigurationswert der Lichteigenschaft zu bestimmen, wobei das Bestimmen des Konfigurationswertes die Mittelung der gemessenen Werte von der Vielzahl von Lichtquellen umfasst, um einen Durchschnittswert als den Konfigurationswert zu erzeugen;
Auswählen einer von einer Vielzahl von unterschiedlichen Toleranzen abhängig vom Konfigurationswert durch die Vorrichtung, die für die Lichteigenschaft spezifisch sind, wobei die Vielzahl von unterschiedlichen Toleranzen, die für die Lichteigenschaft spezifisch sind, in einem Speicher der Vorrichtung gespeichert werden;
Bestimmen eines Schwellenwertes der Lichteigenschaft durch die Vorrichtung durch Anwenden einer Toleranz auf den Konfigurationswert;
Speichern des Schwellenwertes im Speicher der Vorrichtung durch die Vorrichtung;
Vergleichen eines Wertes der Lichteigenschaft gemessen vom Licht, das von einer weiteren externen Lichtquelle empfangen wird, durch die Vorrichtung mit dem Schwellenwert; und
Ausgeben einer Anzeige eines Ergebnisses des Vergleiches durch die Vorrichtung.

11. Verfahren nach Anspruch 10, umfassend das Bestimmen von oberen und unteren Schwellenwerten der Lichteigenschaft durch Anwenden der Toleranz auf den Konfigurationswert.

12. Verfahren nach Anspruch 11, umfassend das Bestimmen des oberen Schwellenwertes durch Addieren der Toleranz zum Konfigurationswert und das Bestimmen des unteren Schwellenwertes durch Subtrahieren der Toleranz vom Konfigurationswert.

## Revendications

1. Dispositif d'analyse de source de lumière, comprenant :
un ou plusieurs capteurs de lumière (2) couplés optiquement par l'intermédiaire d'au moins un guide de lumière (5) à au moins une source de lumière externe (3) ; et
un dispositif de commande (6) pour recevoir des signaux indiquant les propriétés de la lumière détectée par le(s) capteur(s), le(s)dit(s) capteur(s) et ledit dispositif de commande étant conçus pour :
mesurer une valeur d'une propriété de lumière reçue en provenance de la au moins une source de lumière externe ;
déterminer à partir de la valeur mesurée de ladite propriété de lumière reçue une valeur de configuration de ladite propriété de lumière, ladite détermination de la valeur de configuration comprenant l'utilisation de la valeur mesurée directement en tant que valeur de configuration ;
sélectionner l'une d'une pluralité de tolérances différentes spécifiques à ladite propriété de lumière en fonction de la valeur de configuration, ladite pluralité de tolérances différentes spécifiques à ladite propriété de lumière étant stockées dans une mémoire du dispositif ;
déterminer un seuil de ladite propriété de lumière en appliquant la tolérance sélectionnée à la valeur de configuration ;
stocker le seuil dans la mémoire du dispositif ;
comparer une valeur de ladite propriété de lumière mesurée à partir de la lumière reçue en provenance d'une autre source de lumière externe avec le seuil ; et
émettre en sortie une indication d'un résultat de la comparaison.

2. Dispositif selon la revendication 1, ledit dispositif étant conçu pour déterminer des valeurs seuil supérieure et inférieure de la propriété de lumière en appliquant la tolérance à la valeur de configuration.

3. Dispositif selon la revendication 2, ledit dispositif étant conçu pour déterminer la valeur seuil supérieure en ajoutant la tolérance à la valeur de configuration et pour déterminer la valeur seuil inférieure en soustrayant la tolérance de la valeur de configuration.

4. Dispositif d'analyse de source de lumière, comprenant :
une pluralité de capteurs de lumière (2) couplés optiquement par l'intermédiaire d'au moins un guide de lumière (5) à une pluralité de sources de lumière externes (3) ; et
un dispositif de commande (6) pour recevoir des signaux indiquant les propriétés de la lumière détectée par le(s) capteur(s), le(s)dit(s) capteur(s) et ledit dispositif de commande étant conçus pour :
mesurer individuellement des valeurs d'une propriété de lumière reçue en provenance de la pluralité de sources de lumière externes ;
déterminer à partir des valeurs mesurées de ladite propriété de lumière reçue une valeur de configuration de ladite propriété de lumière, ladite détermination de la valeur de configuration comprenant le calcul de la moyenne des valeurs mesurées à partir de la pluralité de sources de lumière pour produire une valeur moyenne en tant que valeur de configuration ;
sélectionner l'une d'une pluralité de tolérances différentes spécifiques à ladite propriété de lumière en fonction de la valeur de configuration, ladite pluralité de tolérances différentes spécifiques à ladite propriété de lumière étant stockées dans une mémoire du dispositif ;
déterminer un seuil de ladite propriété de lumière en appliquant la tolérance sélectionnée à la valeur de configuration ;
stocker le seuil dans la mémoire du dispositif ;
comparer une valeur de ladite propriété de lumière mesurée à partir de la lumière reçue en provenance d'une autre source de lumière externe avec le seuil ; et
émettre en sortie une indication d'un résultat de la comparaison.

5. Dispositif selon la revendication 4, ledit dispositif étant conçu pour déterminer des valeurs seuil supérieure et inférieure de la propriété de la lumière en appliquant la tolérance à la valeur de configuration.

6. Dispositif selon la revendication 5, ledit dispositif étant conçu pour déterminer la valeur seuil supérieure en ajoutant la tolérance à la valeur de configuration et pour déterminer la valeur seuil inférieure en soustrayant la tolérance de la valeur de configuration.

7. Procédé d'analyse d'une source de lumière à l'aide du dispositif d'analyse de source de lumière selon l'une quelconque des revendications 1 à 3, comprenant :
la mesure, par le dispositif, d'une valeur d'une propriété de lumière reçue en provenance d'au moins une source de lumière externe pour déterminer à partir de la lumière reçue une valeur de configuration de ladite propriété de lumière, ladite détermination de la valeur de configuration comprenant l'utilisation de la valeur mesurée directement en tant que valeur de configuration ;
la sélection, par le dispositif, de l'une d'une pluralité de tolérances différentes spécifiques à ladite propriété de lumière en fonction de la valeur de configuration, ladite pluralité de tolérances différentes spécifiques à ladite propriété de lumière étant stockées dans une mémoire du dispositif ;
la détermination, par le dispositif, d'un seuil de ladite propriété de lumière en appliquant une tolérance à la valeur de configuration ;
le stockage, par le dispositif, du seuil dans la mémoire du dispositif ;
la comparaison, par le dispositif, d'une valeur de ladite propriété de lumière mesurée à partir de la lumière reçue en provenance d'une autre source de lumière externe avec le seuil ; et
l'émission en sortie, par le dispositif, d'une indication d'un résultat de la comparaison.

8. Procédé selon la revendication 7, comprenant la détermination des valeurs seuil supérieure et inférieure de la propriété de lumière en appliquant la tolérance à la valeur de configuration.

9. Procédé selon la revendication 8, comprenant la détermination de la valeur seuil supérieure en ajoutant la tolérance à la valeur de configuration et la détermination de la valeur seuil inférieure en soustrayant la tolérance de la valeur de configuration.

10. Procédé d'analyse d'une source de lumière à l'aide du dispositif d'analyse de source de lumière selon l'une quelconque des revendications 4 à 6, comprenant :
la mesure individuelle, par le dispositif, des valeurs d'une propriété de lumière reçue en provenance d'une pluralité de sources de lumière externes pour déterminer à partir de la lumière reçue une valeur de configuration de ladite propriété de lumière, ladite détermination de la valeur de configuration comprenant la calcul de la moyenne des valeurs mesurées à partir de la pluralité de sources de lumière pour produire une valeur moyenne en tant que valeur de configuration ;
la sélection, par le dispositif, de l'une d'une pluralité de tolérances différentes spécifiques à ladite propriété de lumière en fonction de la valeur de configuration, ladite pluralité de tolérances différentes spécifiques à ladite propriété de lumière étant stockées dans une mémoire du dispositif ;
la détermination, par le dispositif, d'un seuil de ladite propriété de lumière en appliquant une tolérance à la valeur de configuration ;
le stockage, par le dispositif, du seuil dans la mémoire du dispositif ;
la comparaison, par le dispositif, d'une valeur de ladite propriété de lumière mesurée à partir de la lumière reçue en provenance d'une autre source de lumière externe avec le seuil ; et
l'émission en sortie, par le dispositif, d'une indication d'un résultat de la comparaison.

11. Procédé selon la revendication 10, comprenant la détermination des valeurs seuil supérieure et inférieure de la propriété de lumière en appliquant la tolérance à la valeur de configuration.

12. Procédé selon la revendication 11, comprenant la détermination de la valeur seuil supérieure en ajoutant la tolérance à la valeur de configuration et la détermination de la valeur seuil inférieure en soustrayant la tolérance de la valeur de configuration.
